# EUROPÄISCHE PATENTSCHRIFT

(11) **EP 1 774 560 B1**
(45) Veröffentlichungstag und Bekanntmachung des Hinweises auf die Patenterteilung: **14.11.2012**
(21) Anmeldenummer: 05769748.4
(22) Anmeldetag: 28.07.2005
(51) Int. Cl.: H01J 37/244, H01J 37/28

(54) **ELEKTRONENSTRAHLGERÄT**
ELECTRONIC BEAM DEVICE
APPAREIL A FAISCEAU ELECTRONIQUE

(30) Priorität: 03.08.2004 DE 102004037781
(43) Veröffentlichungstag der Anmeldung: 18.04.2007
(73) Patentinhaber: Carl Zeiss Microscopy GmbH, 07745 Jena (DE)
(72) Erfinder: ESSERS, Erik, 73430 Aalen (DE); BENNER, Gerd, 73434 Aalen (DE); DREXEL, Volker, 89551 Königsbronn (DE)
(74) Vertreter: Tongbhoyai, Martin
(86) Internationale Anmeldenummer: PCT/EP2005/008216
(87) Internationale Veröffentlichungsnummer: WO 2006/015732

(56) Entgegenhaltungen:
- EP-A- 0 661 727
- DE-A1- 3 703 028
- US-A- 6 104 034
- US-A1- 2003 098 415
- US-A1- 2004 036 030

## Beschreibung

Die Erfindung betrifft ein Elektronenstrahlgerät, insbesondere ein Rasterelektronenmikroskop, mit einem Strahlerzeuger zur Erzeugung eines Elektronenstrahls, einer Objektivlinse zur Fokussierung des Elektronenstrahls auf einem Objekt und mindestens einem Detektor zur Detektion von am Objekt zurückgestreuten oder vom Objekt emittierten Elektronen.

Elektronenstrahlgeräte, insbesondere Rasterelektronenmikroskope, werden zur Untersuchung von Oberflächen von Objekten (Proben) verwendet. Hierzu wird bei einem Rasterelektronenmikroskop ein Elektronenstrahl (nachfolgend auch Primärelektronenstrahl genannt) mittels des Strahlerzeugers erzeugt und durch die Objektivlinse auf das zu untersuchende Objekt fokussiert: Mittels einer Ablenkeinrichtung wird der Primärelektronenstrahl rasterförmig über die Oberfläche des zu untersuchenden Objektes geführt. Die Elektronen des Primärelektronenstrahls treten dabei in Wechselwirkung mit dem Objekt. Als Folge der Wechselwirkung werden insbesondere Elektronen aus dem Objekt emittiert (sogenannte Sekundärelektronen) oder Elektronen des Primärelektronenstrahls zurückgestreut (sogenannte Rückstreuelektronen). Die Rückstreuelektronen weisen dabei eine Energie im Bereich von 50 eV bis zur Energie der Elektronen des Primärelektronenstrahls am Objekt auf, während die Sekundärelektronen eine Energie kleiner als 50 eV aufweisen. Sekundär - und Rückstreuelektronen bilden den nachfolgend sogenannten Sekundärstrahl und werden mit einem Detektor detektiert. Das hierdurch erzeugte Detektorsignal wird zur Bilderzeugung verwendet.

Elektronenstrahlgeräte weisen eine hohe Ortsauflösung auf, die durch einen sehr geringen Durchmesser des Elektronenstrahls in der Ebene des Objektes erzielt wird. Die Auflösung ist um so besser, je näher das Objekt an der Objektivlinse des Elektronenstrahlgerätes angeordnet ist. Zum Nachweis der Sekundär- oder Rückstreuelektronen ist der Detektor hierbei vorzugsweise innerhalb der Objektivlinse oder in einem Bereich zwischen der Objektivlinse und dem Strahlerzeuger angeordnet. Ferner kann die Auflösung insbesondere bei einer Primärelektronenenergie von weniger als 10 keV verbessert werden, indem die Elektronen des Primärelektronenstrahls im Elektronenstrahlgerät zunächst beschleunigt und am Ende in der Objektivlinse oder im Bereich zwischen der Objektivlinse und dem Objekt auf eine gewünschte Endenergie abgebremst werden. Ein derartiges Elektronenstrahlgerät ist beispielsweise in der DE 198 28 476 A1 beschrieben.

Es sind Elektronenstrahlgeräte bekannt, die einen ringförmigen, um die Strahlachse des Primärelektronenstrahls angeordneten Detektor mit einer Öffnung aufweisen, die normalerweise wesentlich größer als der Strahlquerschnitt des Primärelektronenstrahls ist, um den Primärelektronenstrahl im Strahlengang des Elektronenstrahlgeräts nicht zu beeinflussen. Die rücklaufenden Bahnen der Sekundär- und Rückstreuelektronen im Elektronenstrahlgerät werden durch die Objektivlinse aufgrund der unterschiedlichen Energien der Sekundär- und Rückstreuelektronen unterschiedlich beeinflußt. Der Cross-Over des Strahls der Sekundärelektronen liegt dabei näher an dem zu untersuchenden Objekt als der Cross-Over des Strahls der Rückstreuelektronen. Unter bestimmten Betriebsbedingungen, insbesondere bei hoher Vergrößerung und kleinem Arbeitsabstand zwischen Objektivlinse und Probe verlaufen die Sekundär- und/oder Rückstreuelektronen auf derartigen Bahnen, daß ein Großteil der Sekundär- und Rückstreuelektronen durch die Öffnung des Detektors hindurchtritt und somit nicht detektiert wird.

In der DE 198 28 476 A1 ist ein Lösungsweg beschrieben, um dem vorstehend genannten Nachteil zu entgehen. Bei dem aus dieser Druckschrift bekannten Elektronenstrahlgerät sind zwei, jeweils eine Öffnung aufweisende Detektoren für die Sekundär- und Rückstreuelektronen in Richtung der optischen Achse des Elektronenstrahlgerätes zueinander versetzt angeordnet. Der in der Nähe des Objektes angeordnete erste Detektor dient dabei zur Detektion der Elektronen, die unter einem relativ großen Raumwinkel aus dem Objekt austreten, während der im Bereich des Strahlerzeugers angeordnete zweite Detektor zur Detektion der Elektronen dient, die unter einem relativ geringen Raumwinkel aus dem Objekt austreten und durch die für den Durchtritt des Primärelektronenstrahls vorgesehene Öffnung des ersten Detektors hindurchtreten.

Ein weiterer Lösungsvorschlag ist aus der EP 0 661 727 A2 bekannt. Diese Druckschrift betrifft ein Rasterelektronenmikroskop, bei dem mittels eines Wienfilters Sekundär- und Rückstreuelektronen auf verschiedenen Bahnen zu unterschiedlichen Detektoren gelenkt werden. Alternativ hierzu ist vorgesehen, den Detektor als Konversionselektrode auszubilden, mit der es möglich ist, entweder Rückstreuelektronen und Sekundärelektronen einzeln oder gleichzeitig mittels eines einzelnen Detektors zu detektieren.

Eine weitere Wienfilteranordnung ist aus der WO 00/36630 bekannt. Diese Druckschrift betrifft ein Rasterelektronenmikroskop mit zwei oder drei aufeinanderfolgenden Wienfiltern, die zur Ablenkung der aus einem Objekt austretenden Auger-Elektronen dienen. Den Wienfiltern sind Quadrupolfelder überlagert, um die durch die Dispersion in den Wienfiltern verursachten Abbildungsfehler zu kompensieren.

Die EP 0 989 584 A1 betrifft zwei Wienfilter, die zur Reduzierung der Energiebreite des Primärelektronenstrahls vorgesehen und als Quadrupolfilter ausgebildet sind.

Ferner ist aus der EP-A-910 109 A1 eine Objektivlinse zur Beeinflussung eines Elektronenstrahls mit einer magnetischen Einzelpollinse und einer elektrostatischen Linse bekannt, die eine erste und eine zweite Elektrode aufweist, die mit unterschiedlichen Potentialen versehen sind. Die elektrostatische Linse ist dabei in Richtung des Elektronenstrahls nach der magnetischen Einzelpollinse angeordnet, wobei eine der beiden Elektroden der elektrostatischen Linse als Multipol ausgebildet ist. Ferner ist eine Anordnung von magnetischen Multipolelementen vorgesehen, um zusammen mit den Elektroden Wienfilter zu bilden. Diese können derart abgestimmt werden, daß der Primärelektronenstrahl nicht beeinflußt wird, etwaige an einem Objekt (Probe) ausgelöste Sekundär- und Rückstreuelektronen hingegen abgelenkt und einem außeraxialen Detektor zugeführt werden, der beide Signale gemeinsam oder durch einen geeigneten Aufbau getrennt nachweisen kann. Nachteil sämtlicher Wienftiter-Lösungen ist die relativ aufwendige Realisierung bei Rastsrelektronenmikroskopen, da das Strahlführungsrohr der Rasterelektronenm kroskope meist segmentiert werden muß.

Aus der DE 37 03 028 A1 ist Elektronenstrahlgerät in Form eines Rastermikroskops bekannt. Ferner ist ein Strahlerzeuger zur Erzeugung eines Elektronenstrahls vorgesehen. Das bekannte Elektronenstrahlgerät weist eine Objektivlinse zur Fokussierung des Elektronenstrahls auf ein Objekt auf. Darüber hinaus ist bei dem bekannten Elektronenstrahlgerät ein Detektor zur Detektion von am Objekt emittierten Elektronen vorgesehen, wobei der Detektor eine Durchtrittsöffnung für den Durchtritt des Elektronenstrahls in Richtung auf das Objekt aufweist.

Der vorliegenden Erfindung liegt daher die Aufgabe zugrunde, bei einem Elektronensti ahlgerät die Detektion von am Objekt zurückgestreuten Elektronen oder von Objekt emittierten Elektronen zu vereinfachen und zu verbessern.

Diese Aufgabe wird mit einem Elektroncnstrahlgerät bzw. Verfahren mit den Merkmalen der Ansprüche 1, 27 oder 28 gelöst. Vorteilhafte Ausgestaltungen der Erfindung ergeben sich aus den Merkmalen der auf diese Ansprüche zurückbezogenen Ansprüche.

Erfindungsgemäß ist das Elektronenstrahlgerät, insbesondere ein Rasterelektronenmikroskop, mit einem Strahlerzeuger zur Erzeugung eines Elektronenstrahls, einer Objektivlinse zur Fokussierung des Elektronenstrahls auf einem Objekt und mindestens einem Detektor zur Detektion von am Objekt zurückgestreuten oder vom Objekt emittierten Elektronen ausgebildet. Der Detektor weist eine Durchtrittsöffnung für den Durchtritt des Elektronenstrahls in Richtung auf das Objekt auf. Ferner sind eine erste und eine zweite Quadrupoleinrichtung vorgesehen, die hintereinander geschaltet sind.

Ferner ist es vorgesehen, dass die zweite Quadropoleinrichtung zur Formung eines Strahlquerschnitts der von am Objekt zurückgestreuten oder vom Objekt emittierten Elektronen ausgebildet ist. Ferner ist es vorgesehen, dass die erste Quadropoleinrichtung zur Kompensation der Wirkung der zweiten Quadropoleinrichtung auf den Elektronenstrahl ausgebildet ist.

Das erfindungsgemäße Elektronenstrahlgerät beruht auf der Erkenntnis, daß die Delektiert von Sekundär- oder Rückstreuelektronen verbessert werden kann, indem der Strahlquerschnitt der Sekundärelektronen bzw. Rückstreuelektronen geeignet eingestellt wird. Die Einstellung erfolgt dabei derart, daß der Strahl der Sekundärelektronen oder Rückstreuelektronert derart durch eine der Quadrupoleinrichtungen geformt wird, daß nur noch ein sehr geringer Teil durch die Durchtrittsöffnung des Detektors hindurchtreten kann. Der weitaus größere Teil der Sekundär- und Rückstreuelektronen trifft auf eine Detektionsfläche des Detektors und wird detektiert. Mit mindestens einer weiteren Quadrupoleinrichtung wird die Wirkung auf den Primärelektronenstrahl kompensiert Die Erfindung gewährleistet demnach mit einem einfachen axial angeordneten Aufbau eine hohe Detektionsrate an Sekundär- bzw. Rückstreuelektronen. Es ist sowohl die Verwendung von magnetischen als auch von elektrostatischen Quadrupolen möglich. Die Stärke der erforderlichen Quadrupolerregungen varriiert je nach Ausführungsform. Wenn insbesondere bei Ausführungsformen mit stärkeren Quadrupolerregungen die dadurch erzeugten Fehler höherer Ordnung auflösungsbegrenzend sind, können sie durch magnetische oder elektrostatische Multipolelemente höherer Ordnung so weit korrigiert werden, daß sie nicht mehr auflösungsbegrenzend sind.

Es ist vorzugsweise vorgesehen, den Detektor symmetrisch zur Strahlachse des Elektronenstrahls im Elektronenstrahlgerät anzuordnen. Ferner ist es bei einem weiteren bevorzugten Ausführungsbeispiel vorgesehen, die erste und zweite Quadrupoleinrichtung gleichsinnig zu erregen.

Wegen der sphärischen Aperation der Objektivlinse ist es vorteilhaft, eine Aperturblende im Strahlengang des Elektronenstrahls vor einer der Quadrupoleinrichtungen anzuordnen. Ist die Aperturblende oberhalb einer ersten Quadrupoleinrichtung vorgesehen, die näher am Strahlerzeuger als die weitere Quadrupoleinrichtung angeordnet ist, so eignet sich eine Aperturblende mit elliptischer Öffnung, da man bei Anordnung einer Aperturblende mit runder Öffnung oberhalb der ersten Quadrupoleinrichtung ein elliptisches Strahlenbündel in der Objektivlinse erhält, was wegen des Öffnungsfehlers der Objektivlinse nachteilig ist. Alternativ zur Aperturblende mit elliptischer Öffnung ist vorgesehen, zwischen der ersten Quadrupoleinrichtung und dem Detektor eine Aperturblende mit runder Öffnung anzuordnen. Auch auf diese Weise läßt sich ein rundes Strahlenbündel in der Objektivlinse erhalten. Bei beiden vorgenannten Alternativen ist vorgesehen, daß der Strahlquerschnitt des Elektronenstrahls am Strahlerzeuger derart gewählt wird, daß der Querschnitt eine Vorzugsrichtung aufweist, da Elektronen aus einem größeren Winkelbereich, bezogen auf diese Vorzugsrichtung, verwendet werden.

Bei einer weiteren Ausführungsform der Erfindung ist vorgesehen, zusätzlich zu der ersten und der zweiten Quadrupoleinrichtung eine dritte Quadrupoleinrichtung vorzusehen. Dabei sind die erste, die zweite und die dritte Quadrupoleinrichtungen hintereinander geschaltet. Überlegungen ergaben nämlich, daß diese Ausführungsform gewährleistet, daß hierdurch die von der am nächsten zum Objekt angeordneten Quadrupoleinrichtung erzeugten virtuellen Quellen stets zusammenfallen. Die Abbildung der als Strahlerzeuger wirkenden Elektronenquelle durch die Objektivlinse auf das Objekt erfolgt dabei sowohl in X-Richtung als auch in Y-Richtung auf einem identischen Arbeitsabstand, wobei die X-Richtung und die Y-Richtung hier durch zwei Vektoren gegeben sind, die die Ebene aufspannen, in denen der Querschnitt des Primärelektronenstrahls liegt. Demnach bleibt der Strahlquerschnitt des Primärelektronenstrahls nach dieser Quadrupoleinrichtung rund.

Die vorgenannte Ausführungsform mit den drei Quadrupoleinrichtungen ist vorteilhaft derart ausgebildet, daß zwei Quadrupoleinrichtungen gleichsinnig und eine Quadrupoleinrichtung hierzu gegensinnig erregt sind. Die zwischen zwei der Quadrupoleinrichtungen angeordnete weitere Quadrupoleinrichtung gewährleistet, daß der Querschnitt des Elektronenstrahls in der letzten Quadrupoleinrichtung (in Richtung des Strahlverlaufs der Primärelektronen) eine runde Form aufweist. Diese letzte Quadrupoleinrichtung ist dabei nahe der Objektivlinse angeordnet und stellt sicher, daß die durch diese Quadrupoleinrichtung erzeugten virtuellen Quellen des Strahlerzeugers in einer Ebene parallel zur Ebene des Objektes zusammenfallen. Der Querschnitt des Primärelektronenstrahls bleibt hierdurch auch nach Abbildung durch die letzte Quadrupoleinrichtung stets rotationssymmetrisch.

Der Detektor ist vorzugsweise zwischen zwei der Quadrupoleinrichtungen angeordnet. Ferner ist vorgesehen, die Quadrupoleinrichtungen als magnetische oder elektrostatische Quadrupole auszubilden.

Bei einer weiteren Ausführungsform der Erfindung ist die zweite Quadrupoleinrichtung näher an dem Objekt als die erste Quadrupoleinrichtung angeordnet. Ferner ist die zweite Quadrupoleinrichtung im Bereich der Objektivlinse angeordnet. Vorzugsweise ist die erste Quadrupoleinrichtung im Bereich des Strahlerzeugers angeordnet.

Ferner betrifft eine Ausgestaltung der Erfindung ein Elektronenstrahlgerät, insbesondere ein Rasterelektronenmikroskop, an dem ein Strahlerzeuger zur Erzeugung eines Elektronenstrahls und eine Objektivlinse zur Fokussierung des Elektronenstrahls auf einem Objekt vorgesehen sind. Die Objektivlinse weist eine zum Strahlerzeuger und eine zum Objekt gerichtete Seite auf und ist mit einer magnetischen sowie mit einer elektrostatischen Linse versehen. Die elektrostatische Linse weist eine erste und eine zweite Elektrode auf, wobei die zweite Elektrode objektseitig angeordnet ist und einen geringeren Abstand zum Objekt als die erste Elektrode aufweist. Ferner ist mindestens eine objektseitig angeordnete Quadrupoleinrichtung vorgesehen, wobei die zweite Elektrode zumindest teilweise diese Quadrupoleinrichtung bildet. Dieses erfindungsgemäße Elektronenstrahlgerät weist mindestens eines der bereits weiter oben genannten Merkmale auf.

Bei dieser Ausgestaltung ist von Vorteil, daß die Quadrupoleinrichtung sehr nahe an dem Objekt (Probe) angeordnet ist. Somit wirkt die Quadrupoleinrichtung viel stärker auf die vom Objekt emittierten Sekundärelektronen als auf die Elektronen des Primärelektronenstrahls. Ferner kann die Quadrupoleinrichtung gleichzeitig auch als Ablenkeinheit ausgebildet werden, um den Primärelektronenstrahl über das Objekt zu rastern.

Zusätzlich ist es von Vorteil, eine der Quadrupoleinrichtungen oberhalb des Cross-Overs der emittierten Elektronen (Sekundärelektronen) anzuordnen, in dem die vom Objekt emittierten Elektronen (Sekundärelektronen) abgebildet werden. Dies ermöglicht, daß eine besonders hohe Zahl an Sekundärelektronen auf den Detektor trifft und detektiert werden kann.

Bei einer bevorzugten Ausführungsform dieses erfindungsgemäßen Elektronenstrahlgeräts umfaßt die Quadrupoleinrichtung ein Bauteil, das eine Öffnung aufweist, durch die der Elektronenstrahl in Richtung auf das Objekt tritt. Vorzugsweise ist die Öffnung des Bauteils unrund, insbesondere elliptisch, ausgebildet. Diese unrunde Öffnung erzeugt einen starken elektrostatischen und leicht magnetischen Astigmatismus, mit dessen Hilfe das Quadrupolfeld generiert wird.

Von Vorteil ist, daß das Bauteil an der zweiten Elektrode angeordnet werden kann. Insbesondere ist vorgesehen, das Bauteil in der zweiten Elektrode zu integrieren. Die zweite Elektrode weist vorzugsweise eine objektseitig angeordnete Seite auf, an der das Bauteil angeordnet ist. Beispielsweise kann das Bauteil durch Isolatoren von der zweiten Elektrode getrennt an der zweiten Elektrode befestigt werden. Diese Ausführungsform weist den Vorteil auf, daß das Bauteil gleichzeitig als Berührungsschutz dient, so daß die zu untersuchende Probe nicht mit der zweiten Elektrode in Berührung kommt.

Bei einer besonderen Ausführungsform liegen das Bauteil und die zweite Elektrode auf einem vorgebbaren Potential. Dabei ist das Potential der zweiten Elektrode vorzugsweise variabel einstellbar. Auf diese Weise kann zwischen einem schwachen oder starken Quadrupolfeld durch geeignete Wahl des Potentials der zweiten Elektrode gewählt werden. Vorzugsweise ist das Bauteil geerdet.

Bei einer weiteren Ausführungsform der Erfindung ist die Öffnung des Detektors justierbar, d.h., die Ausdehnung der Öffnung ist einstellbar. Vorzugsweise ist die Öffnung des Detektors spaltförmig oder elliptisch ausgebildet. Ferner kann zusätzlich oder alternativ vorgesehen sein, daß der Detektor mit mindestens zwei Detektorelementen ausgebildet ist, die derart zueinander angeordnet sind, daß sie die Öffnung des Detektors bilden. Beispielsweise sind die Detektorelemente an einer Justiereinrichtung angeordnet, mit der die Ausdehnung der Öffnung durch Positionieren der Detektorelemente einstellbar ist. Ferner ist vorzugsweise vorgesehen, den Detektor als Konversionsblende auszubilden. Auf diese Konversionsblende auftreffende Sekundär- oder Rückstreuelektronen erzeugen wiederum Sekundärelektronen von geringer Energie, die mittels eines Detektors, beispielsweise ein Szintillationsdetektor, detektiert werden können. Auch ist es von Vorteil, den Detektor in einem Fokus einer der Quadrupoleinrichtungen anzuordnen.

Die Erfindung betrifft ferner ein Elektronenstrahlgerät, insbesondere ein Rasterelektronenmikroskop, mit einem Strahlerzeuger zur Erzeugung eines Elektronenstrahls, einer Objektivlinse zur Fokussierung des Elektronenstrahls auf einem Objekt, wobei die Objektivlinse eine zum Strahlerzeuger und eine zum Objekt gerichtete Seite aufweist, sowie mindestens einem Detektor zur Detektion von am Objekt zurückgestreuten oder vom Objekt emittierten Elektronen, wobei der Detektor eine Durchtrittsöffnung für den Durchtritt des Elektronenstrahls in Richtung auf das Objekt aufweist. Ferner ist mindestens eine an der Objektivlinse objektseitig angeordnete Quadrupoleinrichtung vorgesehen. Das Elektronenstrahlgerät weist vorzugsweise mindestens eines der vorgenannten Merkmale auf, die bereits weiter oben beschrieben wurden.

Die Erfindung betrifft auch ein Verfahren zur Detektion von Elektronen in einem Elektronenstrahlgerät. Nach diesem Verfahren wird ein Primärelektronenstrahl erzeugt und durch das Elektronenstrahlgerät geführt. Beim Auftreffen des Primärelektronenstrahls auf ein zu untersuchendes Objekt werden Elektronen (Sekundärelektronen und Rückstreuelektronen) erzeugt, die einen

Sekundärstrahl formen. Der Primärelektronenstrahl durchläuft nach seiner

Erzeugung einen ersten Quadrupol, der den Strahlquerschnitt des Primärelektronenstrahls derart formt, daß der Primärelektronenstrahl anschließend durch die Öffnung eines Detektors in Richtung des zu untersuchenden Objektes tritt. Anschließend durchläuft der Primärlektronenstrahl einen zweiten Quadrupol, der den Strahlquerschnitt des Primärelektronenstrahls derart formt, daß er wieder im wesentlichen rotationssymmetrisch ist. Ferner durchläuft der Sekundärstrahl den zweiten Quadrupol und wird durch den zweiten Quadrupol derart geformt, daß nur ein geringer Teil der Elektronen des Sekundärstrahls durch die Öffnung des Detektors tritt und der weitaus größere Teil durch den Detektor detektiert wird.

Das erfindungemäße Verfahren wird weiter unten nochmals eingehend erläutert.

Die Erfindung ist nicht eingeschränkt auf ein Strahlgerät für Elektronen. Vielmehr kann die Erfindung für jedes Teilchenstrahlgerät, insbesondere auch für ein Ionenstrahlgerät, verwendet werden, das mindestens eines der oben genannten Merkmale aufweist.

Die Erfindung wird nun nachfolgend anhand von Ausführungsbeispielen mittels Figuren näher erläutert. Es zeigen:
- Fig. 1: eine schematische Darstellung der prinzipiellen Funktionsweise der Erfindung;
- Fig. 2: eine geschnittene, schematische Darstellung eines Rasterelektronenmikroskops mit zwei Quadrupolen;
- Fig. 3: eine weitere geschnittene, schematische Darstellung eines Rasterelektronenmikroskops mit zwei Quadrupolen;
- Fig. 4: eine geschnittene, schematische Darstellung eines Rasterelektronenmikroskops mit drei Quadrupolen;
- Fig. 5: eine schematische Darstellung des Strahlengangs in X-Richtung eines Primärelektronenstrahls im Rasterelektronenmikroskop gemäß Fig. 4;
- Fig. 6: eine weitere schematische Darstellung des Strahlengangs in Y-Richtung des Primärelektronenstrahls im Rasterelektronenmikroskop gemäß Fig. 4;
- Fig. 7: eine schematische Darstellung der objektseitig angeordneten Ausbildung einer Objektivlinse des Rasterelektronenmikroskops;
- Fig. 8,8a: eine schematische Darstellung einer objektseitig angeordneten Quadrupoleinrichtung; und
- Fig. 9,9a: eine schematische Darstellung einer weiteren an der Objektivlinse objektseitig angeordneten Quadrupoleinrichtung.

Die Erfindung wird nachfolgend am Beispiel eines Teilchenstrahlgerätes bzw. Elektronenstrahlgerätes in Form eines Rasterelektronenmikroskops näher erläutert. Sie ist aber nicht auf Rasterelektronenmikroskope eingeschränkt. Vielmehr kann die Erfindung bei jeglichem Teilchenstrahlgerät, insbesondere auch bei einem Ionenstrahlgerät, verwendet werden.

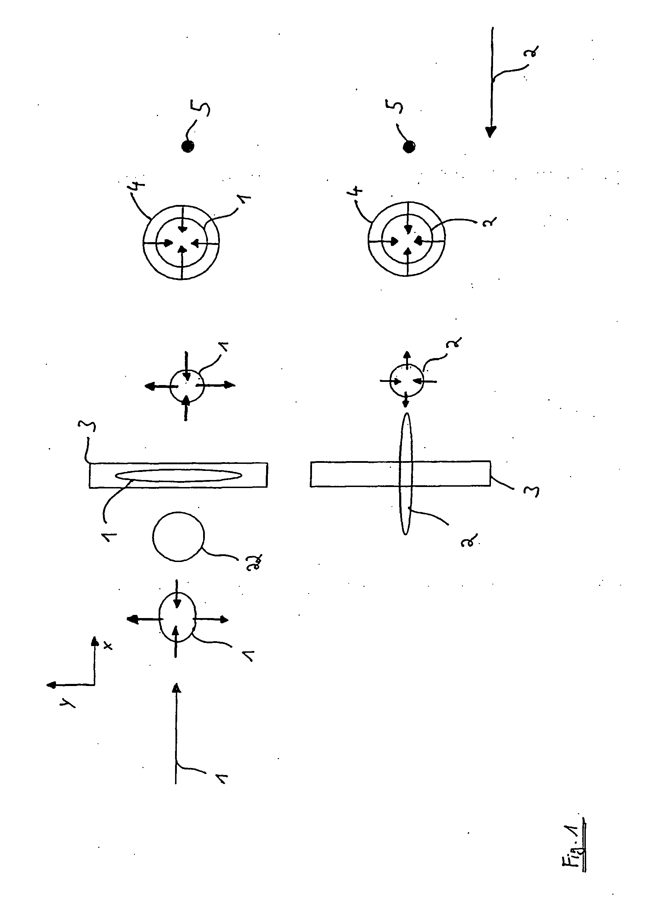

Fig. 1 zeigt die prinzipielle Wirkungsweise der Erfindung. Ein Primärelektronenstrahl 1 läuft entlang einer optischen Achse eines Rasterelektronenmikroskops. Der bis dorthin divergente Primärelektronenstrahl 1 durchläuft zunächst einen im Strahlengang des Rasterelektronenmikroskops angeordneten ersten Quadrupol (Wirkung des Quadrupol ist schematisch durch Pfeile dargestellt). Der Quadrupol wirkt wie eine Zylinderlinse, die dem Primärelektronenstrahl 1 in eine erste Richtung fokussiert (X-Richtung) und in eine zweite, dazu senkrechte Richtung defokussiert (Y-Richtung). Der Primärelektronenstrahl 1 durchläuft anschließend eine Aperturblende 22, deren Funktion bereits oben beschrieben wurde. Die Lage der Aperturblende 22 ist vorzugweise so gewählt, daß der Strahlquerschnitt des Primärelektronenstrahls 1 in der Objektivebene rotationssymmetrisch ist. Anschließend durchläuft der Primärelektronenstrahl 1 eine Detektionsebene, in der ein Detektor (nicht dargestellt) angeordnet ist. Die Längsachse des Primärelektronenstrahls 1 ist in dieselbe Richtung ausgerichtet wie eine Öffnung 3 des Detektors, die vorzugsweise länglich ausgebildet ist. Die Öffnung 3 des Detektors weist mindestens eine derartige Ausdehnung auf, daß der Primärelektronenstrahl 1 ungehindert durch die Öffnung 3 treten kann. Eine weitere vorteilhafte Ausbildungsform stellt eine runde Detektoröffnung dar, die einfacher mit der erforderlichen Oberflächenqualität zu fertigen ist und die Beeinflussung des Primärelektronenstrahls verringert.

Hinter den Detektor ist ein weiterer Quadrupol (Wirkung ist durch Pfeile schematisch dargestellt) geschaltet. Die Fokussierung des ersten Quadrupols in X-Richtung ist dabei stark genug, um ein astigmatisches Zwischenbild quellenseitig vom zweiten Quadrupol zu erzeugen. In Y-Richtung ist bei dem Ausführungsbeispiele hingegen kein Zwischenbild zwischen Kathode (Strahlerzeuger) und Probe vorhanden.

Der zweite Quadrupol ist gleichsinnig zu dem ersten Quadrupol erregt, d.h., er wirkt in dieselbe Richtung fokussierend (X-Richtung). Der Querschnitt des Primärelektronenstrahls 1 wird derart fokussiert und defokussiert, daß der Primärelektronenstrahl 1 wieder rotationssymmetrisch (rund) ist. Eine Objektivlinse 4 fokussiert anschließend den Primärelektronenstrahl 1 auf eine nicht dargestellte Probe, wobei der Fokus 5 auf der Probe punktförmig ausgebildet ist.

Beim Auftreffen des Primärelektronenstrahls 1 auf die Probe werden Elektronen aus dem Objekt emittiert (sogenannte Sekundärelektronen) und Elektronen am Objekt zurückgestreut (sogenannte Rückstreuelektronen). Deren Gesamtheit bildet den Sekundärstrahl 2. Der Sekundärstrahl 2 wird beschleunigt und durch die Objektivlinse 4 zum Detektor fokussiert. Dabei durchlaufen die Sekundär- und Rückstreuelektronen den zwischen Detektor und Objektivlinse 4 geschalteten Quadrupol, der in diesem Ausführungsbeispiel als magnetischer Quadrupol ausgeführt ist. Der Quadrupol bewirkt, daß der Strahl 2 der Sekundärelektronen bzw. Rückstreuelektronen elliptisch geformt wird, wobei die große Achse (Längsachse) der Ellipse im Fall einer länglich ausgebildeten Öffnung 3 senkrecht zur Längsachse der länglich ausgebildeten Öffnung 3 des Detektors ausgerichtet ist. Durch die Aufspreizung des Sekundärstrahls kann nur ein geringer Teil der Sekundär- bzw. Rückstreuelektronen durch die Öffnung 3 des Detektors hindurchtreten. Der weitaus größere Teil trifft auf die Detektionsfläche des Detektors. Somit dient der zweite Quadrupol der Aufspreizung des Sekundärstrahls. Die Wirkung des zweiten Quadrupols auf den Primärelektronenstrahl wird durch den ersten Quadrupol kompensiert.

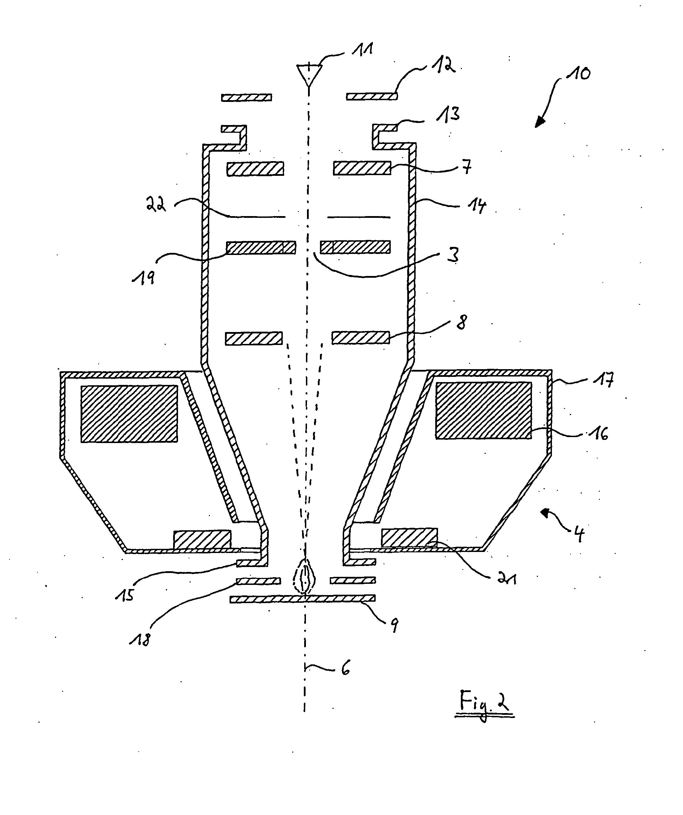

Fig. 2 zeigt eine schematische Darstellung eines Rasterelektronenmikroskops 10 mit zwei magnetischen Quadrupolen 7,8, die gleichsinnig erregt sind und in dieselbe Richtung wirken. Das Rasterelektronenmikroskop 10 weist einen Strahlerzeuger in Form einer Elektronenquelle 11 (Kathode), eine Extraktionselektrode bzw. Steuerelektrode 12 sowie eine Anode 13 auf, die gleichzeitig ein Ende eines Strahlführungsrohres 14 des Rasterelektronenmikroskops 10 bildet. Vorzugsweise ist die Elektronenquelle 11 ein thermischer Feldemitter. Elektronen, die aus der Elektronenquelle 11 austreten, werden aufgrund einer Potentialdifferenz zwischen der Elektronenquelle 11 und der Anode 13 auf Anodenpotential beschleunigt.

Das Strahlführungsrohr 14 ist durch eine Bohrung durch Polschuhe 17 einer als Objektiv wirkenden Magnetlinse 4 geführt. In den Polschuhen 17 sind Spulen 16 angeordnet, wie sie bereits seit langem bekannt sind. Hinter das Strahlführungsrohr 14 ist eine elektrostatische Verzögerungseinrichtung geschaltet. Diese besteht aus einer Elektrode 18 und einer an dem probenseitigen Ende des Strahlführungsrohres 14 ausgebildeten Rohrelektrode 15. Somit liegt die Rohrelektrode 15 gemeinsam mit dem Strahlführungsrohr 14 auf Anodenpotential, während die Elektrode 18 sowie die Probe 9 auf einem gegenüber dem Anodenpotential niedrigeren Potential liegen. Auf diese Weise können die Elektronen des Primärelektronenstrahls auf eine gewünschte niedrige Energie abgebremst werden, die für die Untersuchungen der Probe erforderlich ist. Ferner ist ein Ablenksystem 21 vorgesehen, durch das der Primärelektronenstrahl abgelenkt und über die Probe 9 gerastert werden kann.

Zur Detektion von Sekundärelektronen oder Rückstreuelektronen, die aufgrund der Wechselwirkung des Primärelektronenstrahls mit der Probe 9 entstehen, ist ein Detektor 19 vorgesehen, der im Strahlführungsrohr 14 des Rasterelektronenmikroskops 10 oberhalb der Objektivlinse 4 angeordnet ist. Der Detektor kann als Konversionselektrode ausgebildet sein, der bei auf diesen treffenden Sekundär- oder Rückstreuelektronen wiederum Sekundärelektronen von niedriger Energie erzeugt, die mit einem nicht dargestellten Detektor detektiert werden können. Ferner weist der Detektor 19 vorzugsweise eine länglich ausgebildete Öffnung 3 auf, die vorzugsweise eine spaltförmige oder ellipsenförmige Ausbildung aufweist und deren Ausdehnung einstellbar sein kann. Bei dem dargestellten Ausführungsbeispiel besteht der Detektor 19 aus zwei Detektorelementen, die zueinander beweglich angeordnet sind.

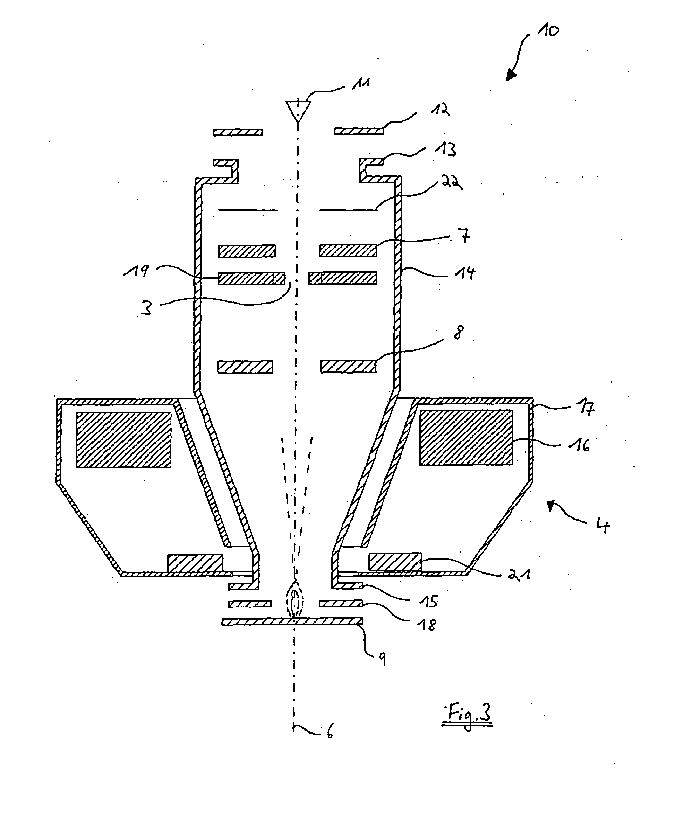

Durch Anordnung einer Aperturblende 22 mit einer runden Öffnung oberhalb des Quadrupols 7 erhält man einen elliptischen Querschnitt des Primärelektronenstrahls in der Objektivlinse 4. Dies ist aufgrund des Öffnungsfehlers der Objektivlinse 4 aber nicht von Vorteil. Daher sollte die Aperturblende 22 eine elliptische Öffnung aufweisen, falls die Aperturblende 22 oberhalb des Quadrupols 7 angeordnet ist (vgl. Fig. 3). Alternativ hierzu kann vorgesehen sein, die Aperturblende 22 mit runder Blendenöffnung zwischen dem Quadrupol 7 und dem Detektor 19 so anzuordnen, daß ein rotationssymmetrischer oder zumindest annähernd rotationssymmetrischer (runder) Querschnitt des Primärelektronenstrahls in der Objektivlinse 4 entsteht.

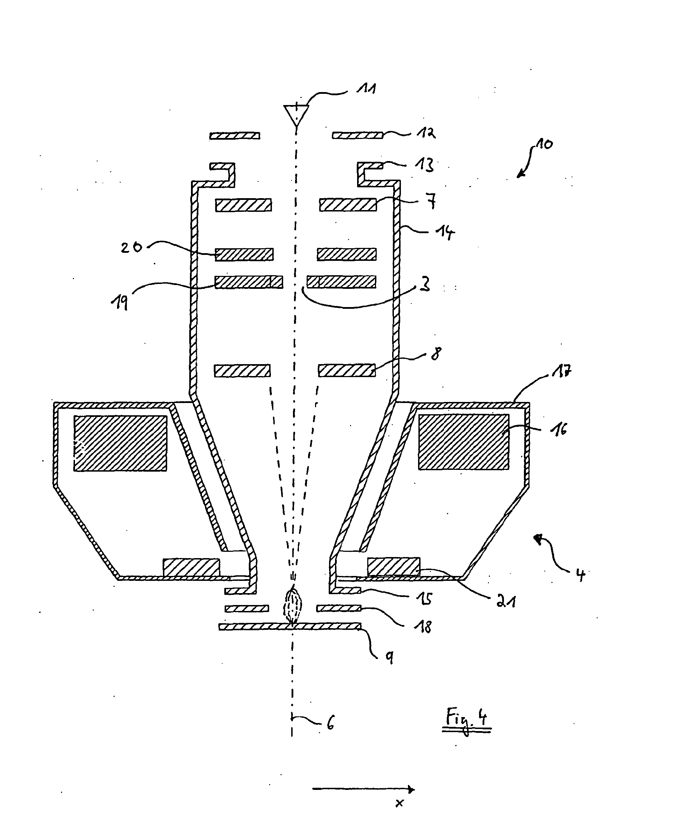

Ein weiteres Ausführungsbeispiel der Erfindung zeigt Fig. 4. Das in Fig. 4 dargestellte Rasterelektronenmikroskop 10 entspricht im Grunde dem in den Fig. 2 und 3 dargestellten Rasterelektronenmikroskop. Allerdings weist dieses Ausführungsbeispiel anstatt zwei Quadrupole drei Quadrupole 7, 8 und 20 auf. Der erste Quadrupol 7 ist im Bereich des Strahlerzeugers 11 angeordnet, während der zweite Quadrupol 8 im Bereich der Objektivlinse 4 angeordnet ist. Der dritte Quadrupol 20 ist zwischen dem ersten Quadrupol 7 und dem Detektor 19 angeordnet.

Der erste und der zweite Quadrupol 7,8 sind gleichsinnig erregt. Hingegen ist der dritte Quadrupol 20 zu den beiden anderen Quadrupolen 7,8 entgegengesetzt erregt. Mittels des Quadrupols 7 wird ein einfallender rotationssymmetrischer Primärelektronenstrahl elliptisch geformt. Der Primärelektronenstrahl tritt anschließend durch die Öffnung 3 des Detektors 19 hindurch, die bevorzugt länglich ausgebildet ist. Aufgrund der Verwendung von drei Quadrupolen erfolgt eine stärkere Verkleinerung der Quelle in beide Richtungen (sowohl X-Richtung als auch Y-Richtung). Ferner wird die rotationssymetrische Strahllage der Kathode auf die Probe abgebildet. Die Größe des Bildes der virtuellen Quelle auf der Probe ist somit in beiden Richtungen gleich groß. Hierdurch bleibt der Querschnitt des Primärelektronenstrahls nach dem Quadrupol 8 immer rotationssymmetrisch. Mittels des dritten Quadrupols 20 wird im Quadrupol 8 stets ein rotationssymmetrischer (runder) Querschnitt des Primärelektronenstrahls erzeugt. Um dies zu erzielen, muß seine Erregung stets entgegengesetzt zu der Erregung des Quadrupols 7 sein.

Im Prinzip kann der dritte Quadrupol 20 im gesamten Bereich des Strahlführungsrohres 14 angeordnet sein. Vorzugsweise ist er aber nahe der Öffnung 3 des Detektors 9 angeordnet, um zu vermeiden, daß die Erregung der einzelnen Quadrupole sehr stark sein muß.

Wie dargestellt, ist der Quadrupol 8 (elektrostatisch) oberhalb eines Cross-Overs für die Sekundärelektronen angeordnet. Auf diese Weise wirkt der Quadrupol 8 derart auf die Sekundärelektronen, daß sich die Ausdehnung des Sekundärelektronenstrahls in zur Öffnung 3 des Detektors 19 senkrechten Richtung erhöht, so daß eine größere Anzahl von Sekundärelektronen auf den Detektor 19 einfallen.

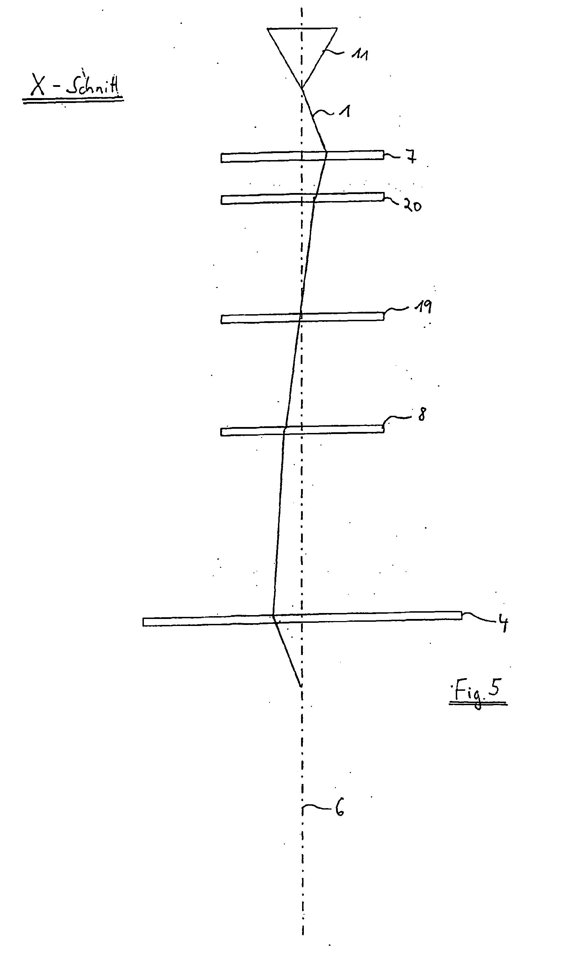

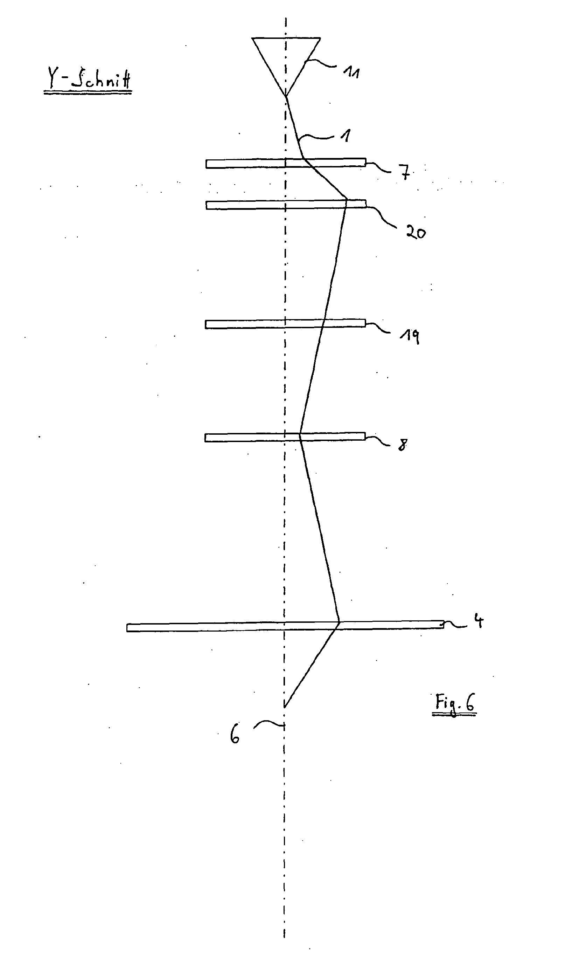

Fig. 5 und 6 zeigen den Verlauf des Primärelektronenstrahls 1 im Rasterelektronenmikroskop 10. Fig. 5 stellt dabei einen Schnitt in X-Richtung, Fig. 6 einen Schnitt in Y-Richtung dar. In X-Richtung wird der Primärelektronenstrahl 1 durch den Quadrupol 7 zunächst fokussiert, d.h. zur optischen Achse 6 hin gelenkt. Der Quadrupol 20 wirkt auf den Primärelektronenstrahl 1 defokussierend bevor er auf den Detektor 19 trifft. Der Primärelektronenstrahl 1 tritt dann durch die Öffnung des Detektors 19 hindurch. Der Quadrupol 8 wirkt auf den Primärelektronenstrahl 1 fokussierend und bildet den Primärelektronenstrahl 1 auf die Objektivlinse 4 ab. Fig. 6 zeigt den Schnitt in Y-Richtung. Zunächst wird der Primärelektronenstrahl 1 aufgrund des Quadrupols 7 defokussiert. Der Quadrupol 20 wirkt fokussierend auf den Primärelektronenstrahl 1, bevor der Primärelektronenstrahl 1 durch die Öffnung des Detektors 19 tritt. Der Quadrupol 8 hingegen wirkt defokussierend auf den Primärelektronenstrahl 1, bevor dieser auf die Objektivlinse 4 trifft.

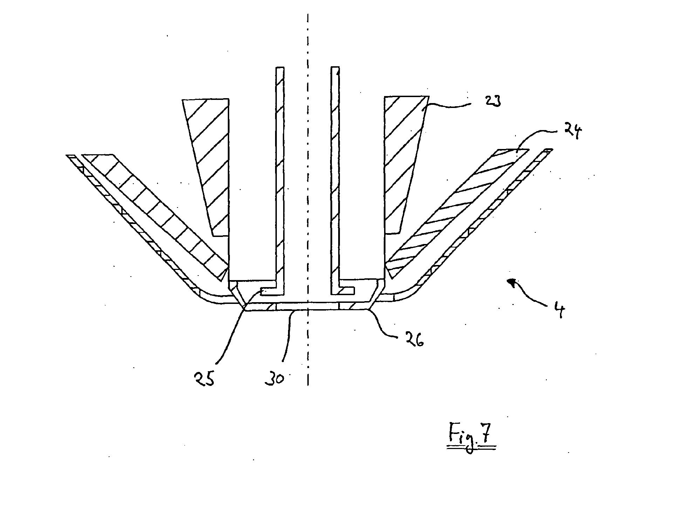

Fig. 7 zeigt schematisch eine Darstellung des objektseitigen Endes einer Objektivlinse 4 mit Polschuhen 23,24 einer magnetischen Linse sowie Elektroden 25,26 einer elektrostatischen Linse, deren Anordnung sowie Funktion bereits aus dem Stand der Technik bekannt sind. Die Elektrode 26 ist in Form einer Abdeckkappe ausgebildet, die eine Öffnung 30 aufweist. Sie wird mittels einer nicht dargestellten Federbügelanordnung an der Objektivlinse 4 gehalten. Wie oben bereits beschrieben, ist es vorteilhaft, eine Quadrupoleinrichtung objektseitig vor der elektrostatischen Linse 25, 26 anzuordnen, da das Quadrupolfeld viel stärker auf die "langsamen" Sekundärelektronen als auf die "schnelleren" Elektronen des Primärelektronenstrahls wirkt. Zusäzlich ist die Strahlhöhe der Sekundärelektronen und damit die Wirkstärke gegenüber dem Primärelektronenstrahl deutlich höher. Dabei ist es vorgesehen, die Elektrode 26 als Teil der Quadrupoleinrichtung auszubilden. Dieses Ausführungsbeispiel kann beispielsweise auch bei den bisher beschriebenen Ausführungsformen der Erfindung verwirklicht werden.

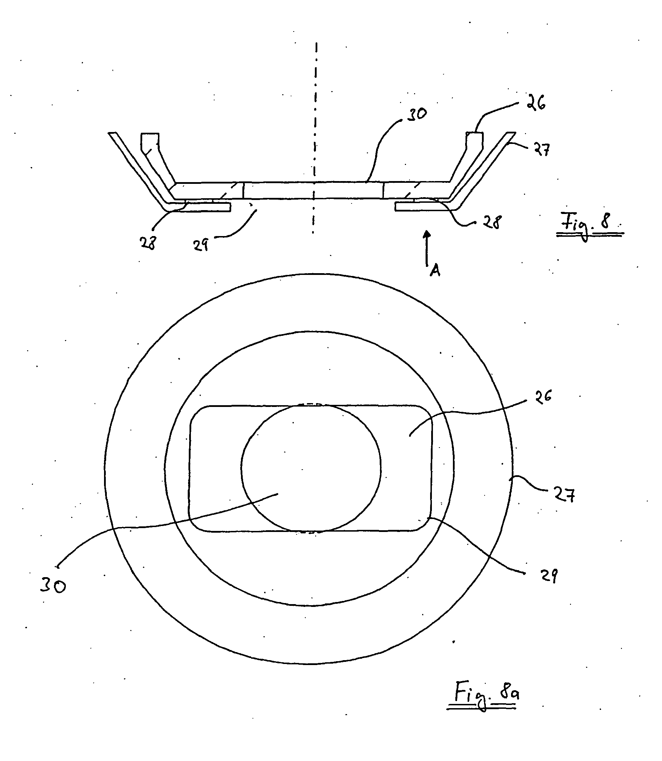

Fig. 8 zeigt eine schematische Darstellung einer Quadrupoleinrichtung in Form eines Quadrupols in einer Schnittdarstellung. An der Elektrode 26 ist über Isolatoren 28 eine weitere Elektrode 27 angeordnet, die eine unrunde Öffnung 29 aufweist. Fig. 8a zeigt eine Draufsicht in Pfeilrichtung A gemäß Fig. 8, die um 90° gedreht ist. Die Elektrode 27 liegt bei diesem Ausführungsbeispiel auf Masse, während die Elektrode 26 auf einem variablen Potential liegt. Somit kann zwischen einem schwachen Quadrupol (Elektrode 26 ebenfalls auf Masse) sowie einem starken Quadrupol (Elektrode 26 auf einem positiven Potential) umgeschaltet werden.

Die vorbeschriebene Ausführungsform weist im Falle des schwachen Quadrupols den Vorteil auf, daß das Quadrupolfeld durch eine unter der Elektrode 26 liegende, unrunde Öffnung 29 der Elektrode 27 nur mit dem Felddurchgriff der elektrostatischen Linse realisiert wird. Außerdem handelt es sich um eine besonders einfache und kostengünstige Lösung. Gleichzeitig dient die Elektrode 27 als Berührungsschutz, so daß die zu untersuchende Probe nicht mit der Elektrode 26 in Kontakt gebracht wird.

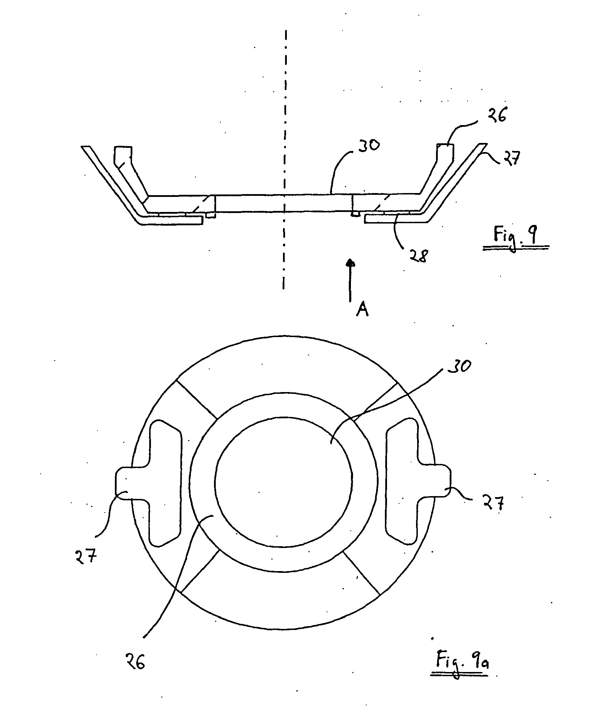

Die Figuren 9 und 9a zeigen ein weiteres Ausführungsbeispiel einer an der Objektivlinse objektseitig angeordneten Quadrupoleinrichtung gemäß der vorliegenden Erfindung. Auch dieses Ausführungsbeispiel weist - wie das in Fig. 7 dargestellte Ausführungsbeispiel - eine Elektrode 26 einer elektrostatischen Linse auf, wobei die Elektrode 26 wiederum mit einer Öffnung 30 versehen ist. An der zu dem Objekt zugewandten Seite der Elektrode 26 ist über Isolatoren eine Elektrode 27 in Form von zwei diametral angeordneten Elektrodenelementen angeordnet. Die Elektroden 26 und 27 weisen jeweils ein derartiges Potential auf, daß ein Quadrupolfeld erzeugt wird.

Die in den Figuren 7 bis 9 dargestellten Ausführungsbeispiele weisen vorzugsweise einen weiteren Quadrupol auf, der im Elektronenstrahlgerät auf der zum Strahlerzeuger angeordneten Seite der Objektivlinse angeordnet ist, beispielsweise in der bereits weiter oben beschriebenen Weise. Dieser weitere Quadrupol ist vorgesehen, den Astigmatismus des Primärelektronenstrahls zu kompensieren, der durch die objektseitig an der Objektivlinse angeordnete Quadruploleinrichtung erzeugt wird.

### Bezugszeichenliste

- 1: Primärelektronenstrahl
- 2: Sekundärstrahl
- 3: Öffnung im Detektor
- 4: Objektivlinse
- 5: Fokus auf der Probe
- 6: optische Achse
- 7: Quadrupol
- 8: Quadrupol
- 9.: Probe
- 10: Rasterelektronenmikroskop
- 11: Elektronenquelle
- 12: Extraktionselektrode
- 13: Anode
- 14: Strahlführungsrohr
- 15: Rohrelektrode
- 16: Spulen einer magnetischen Linse
- 17: Polschuh der als Objektiv wirkenden Magnetlinse
- 18: Elektrode
- 19: Detektor
- 20: Quadrupol
- 21: Ablenksystem
- 22: Aperturblende
- 23: Polschuh
- 24: Polschuh
- 25: Elektrode
- 26: Elektrode
- 27: Elektrode
- 28: Isolator
- 29: Öffnung
- 30: Öffnung

## Patentansprüche

1. Elektronenstrahlgerät (10), insbesondere ein Rasterelektronenmikroskop, mit
- einem Strahlerzeuger (11) zur Erzeugung eines Elektronenstrahls (1),
- einer Objektivlinse (4, 17) zur Fokussierung des Elektronenstrahls (1) auf einem Objekt (9),
- mindestens einem Detektor (19) zur Detektion von am Objekt (9) zurückgestreuten oder vom Objekt emittierten Elektronen (2), wobei der Detektor (19) eine Durchtrittsöffnung (3) für den Durchtritt des Elektronenstrahls (1) in Richtung auf das Objekt (9) aufweist,
**gekennzeichnet durch**
- eine erste und eine zweite Quadrupoleinrichtung (7, 8, 20, 26, 27), die hintereinandergeschaltet sind,
wobei
- die zweite Quadrupoleinrichtung (8) zur Formung eines Strahlquerschnitts der von am Objekt (9) zurückgestreuten oder vom Objekt (9) emittierten Elektronen ausgebildet ist, und wobei
- die erste Quadrupoleinrichtung (7) zur Kompensation der Wirkung der zweiten Quadrupoleinrichtung (8) auf den Elektronenstrahl (1) ausgebildet ist.

2. Elektronenstrahlgerät nach Anspruch 1, wobei der Detektor (19) symmetrisch zur Strahlachse (6) des Elektronenstrahls (1) im Elektronenstrahlgerät (10) angeordnet ist.

3. Elektronenstrahlgerät nach Anspruch 1 oder 2, wobei die erste und die zweite Quadrupoleinrichtung (7, 8) gleichsinnig erregt sind.

4. Elektronenstrahlgerät nach einem der vorangehenden Ansprüche, wobei vor einer der Quadrupoleinrichtungen (8) eine Aperturblende (22) angeordnet ist.

5. Elektronenstrahlgerät nach Anspruch 4, wobei die Aperturblende (22) zwischen der ersten Quadrupoleinrichtung (7) und dem Detektor (19) angeordnet ist.

6. Elektronenstrahlgerät nach einem der vorangehenden Ansprüche, wobei zusätzlich zu der ersten und der zweiten Quadrupoleinrichtung (7, 8) eine dritte Quadrupoleinrichtung (20) vorgesehen ist, und die erste, zweite und dritte Quadrupoleinrichtung (7, 8, 20) hintereinandergeschaltet sind.

7. Elektronenstrahlgerät nach Anspruch 6, wobei zwei Quadrupoleinrichtungen (7, 8) gleichsinnig erregt und eine Quadrupoleinrichtung (20) hierzu gegensinnig erregt sind.

8. Elektronenstrahlgerät nach einem der vorangehenden Ansprüche, wobei der Detektor (19) zwischen zwei Quadrupoleinrichtungen (7, 8) angeordnet ist.

9. Elektronenstrahlgerät nach einem der vorangehenden Ansprüche, wobei die Quadrupoleinrichtungen (7, 8, 20, 26, 27) als magnetische oder elektrostatische Quadrupole ausgebildet sind.

10. Elektronenstrahlgerät nach einem der vorangehenden Ansprüche, wobei die zweite Quadrupoleinrichtung (8) näher an dem Objekt (9) als die erste Quadrupoleinrichtung (7) angeordnet ist, und wobei die zweite Quadrupoleinrichtung (8) im Bereich der Objektivlinse angeordnet ist.

11. Elektronenstrahlgerät nach einem der vorangehenden Ansprüche, wobei die erste Quadrupoleinrichtung (7) im Bereich des Strahlerzeugers (11) angeordnet ist.

12. Elektronenstrahlgerät nach einem der vorangehendenden Ansprüche, wobei die Objektivlinse (4, 17) eine zum Strahlerzeuger (11) und eine zum Objekt (9) gerichtete Seite aufweist sowie mit einer magnetischen und einer elektrostatischen Linse (23, 24, 25, 26) versehen ist, die eine erste und eine zweite Elektrode (25, 26) aufweist, wobei die zweite Elektrode (26) objektseitig angeordnet ist und einen geringeren Abstand zum Objekt (9) als die erste Elektrode (25) aufweist, und wobei eine der Quadrupoleinrichtungen (26, 27) objektseitig angeordnet ist und die zweite Elektrode (26) zumindest teilweise diese Quadrupoleinrichtung bildet.

13. Elektronenstrahlgerät nach Anspruch 12, wobei eine weitere der Quadrupoleinrichtungen (7, 8, 20) oberhalb des Cross-Overs der emittierten Elektronen (Sekundärelektronen) angeordnet ist, in dem die vom Objekt emittierten Elektronen (Sekundärelektronen) abgebildet werden.

14. Elektronenstrahlgerät nach Anspruch 12, wobei die Quadrupoleinrichtung ein Bauteil (27) umfaßt, das eine Öffnung (29) aufweist, und der Elektronenstrahl durch diese Öffnung (29) in Richtung des Objekts (9) tritt.

15. Elektronenstrahlgerät nach Anspruch 14, wobei die Öffnung (29) des Bauteils (27) unrund, insbesondere elliptisch, ausgebildet ist.

16. Elektronenstrahlgerät nach einem der Ansprüche 12, 14 oder 15, wobei das Bauteil (27) an der zweiten Elektrode (26) angeordnet ist.

17. Elektronenstrahlgerät nach einem der Ansprüche 12 oder 14 bis 16, wobei das Bauteil (27) in der zweiten Elektrode (26) integriert ist.

18. Elektronenstrahlgerät nach einem der Ansprüche 12 oder 14 bis 17, wobei die zweite Elektrode (26) eine objektseitig angeordnete Seite aufweist, an der das Bauteil (27) angeordnet ist.

19. Elektronenstrahlgerät nach Anspruch 18, wobei das Bauteil (27) durch Isolatoren (28) von der zweiten Elektrode (26) getrennt ist.

20. Elektronenstrahlgerät nach Anspruch 18 oder 19, wobei das Bauteil (27) und die zweite Elektrode (26) auf einem vorgebbaren Potential liegen, und wobei das Potential der zweiten Elektrode (26) variabel einstellbar ist.

21. Elektronenstrahlgerät nach Anspruch 20, wobei das Bauteil (27) geerdet ist.

22. Elektronenstrahlgerät nach einem der vorangehenden Ansprüche, wobei der Detektor (19) eine justierbare Öffnung (3) aufweist.

23. Elektronenstrahlgerät nach einem der vorangehenden Ansprüche, wobei die Öffnung (3) des Detektors (19) spaltförmig oder elliptisch ausgebildet ist.

24. Elektronenstrahlgerät nach Anspruch 23, wobei der Detektor (19) in einem Fokus einer der Quadrupoleinrichtungen angeordnet ist.

25. Elektronenstrahlgerät nach einem der vorangehenden Ansprüche, wobei der Detektor (19) mindestens zwei Detektorelemente zur Bildung der Öffnung (3) aufweist.

26. Elektronenstrahlgerät nach einem der vorangehenden Ansprüche, wobei der Detektor (19) als Konversionsblende ausgebildet ist.

27. Elektronenstrahlgerät (10), insbesondere ein Rasterelektronenmikroskop, mit
- einem Strahlerzeuger (11) zur Erzeugung eines Elektronenstrahls (1),
- einer Objektivlinse (4, 17) zur Fokussierung des Elektronenstrahls (1) auf einem Objekt (9), wobei die Objektivlinse linse (4, 17) eine zum Strahlerzeuger (11) und eine zum Objekt (9) gerichtete Seite aufweist,
- mindestens einem Detektor (19) zur Detektion von am Objekt (9) zurückgestreuten oder vom Objekt (9) emittierten Elektronen, wobei der Detektor (19) eine Durchtrittsöffnung (3) für den Durchtritt des Elektronenstrahls (1) in Richtung auf das Objekt (9) aufweist,
**gekennzeichnet durch**
- mindestens eine an der Objektiv linse (4, 17) objektseitig angeordnete Quadrupoleinrichtung (26, 27).

28. Verfahren zur Detektion von Elektronen in einem Elektronenstrahlgerät (10), bei dem ein Primärelektronenstrahl (1), erzeugt und durch das Elektronenstrahlgerät (10) geführt wird, und bei dem bei einem Auftreffen des Primärelektronenstrahls (1) auf ein zu untersuchendes Objekt (9) Elektronen erzeugt werden, die einen Sekundäretrahl (2) formen, **dadurch gekennzeichnet dass**
- der Primärelektronenstrahl (1) einen ersten Quadrupol (7) durchläuft, der den Strahlquerschnitt des Primärelektronenstrahls (1) derart formt, daß der Primärelektronenstrahl (1) anschließend durch die Öffnung (3) eines Detektors (19) in Richtung des zu untersuchenden Objektes (9) tritt;
- der Primärlektronenstrahl (1) anschließend einen zweiten Quadrupol (8) durchläuft, der den Strahlquerschnitt des Primärelektronenstrahls (1) derart formt, daß er wieder im wesentlichen rotationssymmetrisch ist; und bei dem
- der Sekundärstrahl (2) den zweiten Quadrupol (8) durchläuft und durch den zweiten Quadrupol (8) derart geformt wird, daß nur ein geringer Teil der Elektronen des Sekundärstrahls (2) durch die Öffnung des Detektors (19) tritt und der weitaus größere Teil durch den Detektor (19) detektiert wird.

29. Verfahren nach Anspruch 28, bei dem der Primärelektronenstrahl (1) einen dritten Quadrupol (20) durchläuft.

## Claims

1. Electron beam device (10), in particular a scanning electron microscope, comprising
- a beam generator (11) for generating an electron beam (1),
- an objective lens (4, 17) for focusing the electron beam (1) on an object (9),
- at least one detector (19) for detecting electrons (2) backscattered on the object (9) or emitted by the object (9), the detector (19) having a through-opening (3) for the passage of the electron beam (1) in the direction of the object (9),
**characterized by**
- a first and a second quadrupole device (7, 8, 20, 26, 27) connected in series,
wherein
- the second quadrupole device (8) is designed for shaping a beam cross section of electrons backscattered on the object (9) or emitted by the object (9), and wherein
- the first quadrupole device (7) is designed for compensating the impact of the second quadrupole device (8) on the electron beam (1).

2. Electron beam device as recited in claim 1, wherein the detector (19) is situated symmetrically with respect to the beam axis (6) of the electron beam (1) in the electron beam device (10).

3. Electron beam device as recited in claim 1 or 2, wherein the first and second quadrupole devices (7, 8) are excited in the same direction.

4. Electron beam device as recited in one of the preceding claims, wherein an aperture stop (22) is situated in front of one of the quadrupole devices (8).

5. Electron beam device as recited in claim 4, wherein the aperture stop (22) is situated between the first quadrupole device (7) and the detector (19).

6. Electron beam device as recited in one of the preceding claims, wherein a third quadrupole device (20) is provided in addition to the first and second quadrupole devices (7, 8), and the first, second, and third quadrupole devices (7, 8, 20) are connected in series.

7. Electron beam device as recited in claim 6, wherein two quadrupole devices (7, 8) are excited in the same direction and one quadrupole device (20) is excited in the opposite direction.

8. Electron beam device as recited in one of the preceding claims, wherein the detector (19) is situated between two quadrupole devices (7, 8).

9. Electron beam device as recited in one of the preceding claims, wherein the quadrupole devices (7, 8, 20, 26, 27) are designed as magnetic or electrostatic quadrupoles.

10. Electron beam device as recited in one of the preceding claims, wherein the second quadrupole device (8) is situated closer to the object (9) than the first quadrupole device (7) and wherein the second quadrupole device (8) is situated in the area of the objective lens.

11. Electron beam device as recited in one of the preceding claims, wherein the first quadrupole device (7) is situated in the area of the beam generator (11).

12. Electron beam device as recited in one of the preceding claims, wherein the objective lens (4, 17) has a side facing the beam generator (11) and a side facing the object (9) and is equipped with a magnetic lens and an electrostatic lens (23, 24, 25, 26), having a first and second electrode (25, 26), wherein the second electrode (26) is situated on the object side and is at a smaller distance from the object (9) than the first electrode (25), and wherein one of the quadrupole devices (26, 27) is situated on the object side and the second electrode (26) forms this quadrupole device at least partially.

13. Electron beam device as recited in claim 12, wherein another of the quadrupole devices (7, 8, 20) is situated above the crossover of the emitted electrons (secondary electrons) in which the electrons (secondary electrons) emitted by the object are imaged.

14. Electron beam device as recited in claim 12, wherein the quadrupole device comprises a component (27) having an opening (29) and the electron beam passes through this opening (29) in the direction of the object (9).

15. Electron beam device as recited in claim 14, wherein the opening (29) in the component (27) is designed to be nonround, in particular elliptical.

16. Electron beam device as recited in one of claims 12, 14 or 15, wherein the component (27) is situated on the second electrode (26).

17. Electron beam device as recited in one of claims 12 or 14 through 16, wherein the component (27) is integrated into the second electrode (26).

18. Electron beam device as recited in one of claims 12 or 14 through 17,
wherein the second electrode (26) has a side situated on the object side on which the component (27) is situated.

19. Electron beam device as recited in claim 18, wherein the component (27) is separated by insulators (28) from the second electrode (26).

20. Electron beam device as recited in claim 18 or 19, wherein the component (27) and the second electrode (26) are at a preselectable potential and wherein the potential of the second electrode (26) is variably adjustable.

21. Electron beam device as recited in claim 20, wherein the component (27) is grounded.

22. Electron beam device as recited in one of the preceding claims, wherein the detector (19) has an adjustable opening (3).

23. Electron beam device as recited in one of the preceding claims, wherein the opening (3) in the detector (19) is designed to be gap shaped or elliptical.

24. Electron beam device as recited in claim 23, wherein the detector (19) is situated in a focus of one of the quadrupole devices.

25. Electron beam device as recited in one of the preceding claims, wherein the detector (19) has at least two detector elements to form the opening (3).

26. Electron beam device as recited in one of the preceding claims, wherein the detector (19) is designed as a conversion stop.

27. Electron beam device (10), in particular a scanning electron microscope, comprising
- a beam generator (11) for generating an electron beam (1),
- an objective lens (4, 17) for focusing the electron beam (1) on an object (9), the objective lens (4, 17) having a side facing the beam generator (11) and a side facing the object (9),
- at least one detector (19) for detecting electrons backscattered on the object (9) or emitted by the object (9), the detector (19) having a through-opening (3) for the passage of the electron beam (1) in the direction of the object (9),
**characterized by**
- at least one quadrupole device (26, 27) situated on the objective lens (4, 17) on the object side.

28. Method for detection of electrons in an electron beam device (10) in which a primary electron beam (1) is generated and is guided through the electron beam device (10) and in which electrons are generated when the primary electron beam (1) strikes an object (9) to be examined and these electrons form a secondary beam (2), **characterized in that**
- the primary electron beam (1) passes through a first quadrupole (7) that shapes the beam cross section of the primary electron beam (1) in such a way that the primary electron beam (1) then passes through the opening (3) in a detector (19) in the direction of the object (9) to be examined;
- the primary electron beam (1) then passes through a second quadrupole (8) that shapes the beam cross section of the primary electron beam (1) in such a way that it is again essentially rotationally symmetrical, and in which
- the secondary beam (2) passes through the second quadrupole (8) and is shaped by the second quadrupole (8) in such a way that only a small portion of the electrons of the secondary beam (2) passes through the opening in the detector (19) and the far greater portion is detected by the detector (19).

29. The method as recited in claim 28, wherein the primary electron beam (1) passes through a third quadrupole (20).

## Revendications

1. Dispositif à faisceau d'électrons (10), en particulier un microscope à balayage électronique, comportant
- un générateur de faisceau (11) pour générer un faisceau d'électrons (1),
- une lentille d'objectif (4, 17) pour focaliser le faisceau d'électrons (1) sur un objet (9),
- au moins un détecteur (19) pour une détection d'électrons (2) réfléchis par un objet (9), ou émis par celui-ci, le détecteur (19) comportant une ouverture traversante (3) pour le passage du faisceau d'électrons (1) en direction de l'objet (9),
**caractérisé par**
- des premier et deuxième agencements quadripolaires (7, 8, 20, 26, 27), connectés en série,
- le deuxième agencement quadripolaire (8) étant conçu pour former une coupe transversale de faisceau des électrons réfléchis par un objet (9), ou émis par celui-ci, et
- le premier agencement quadripolaire (7) étant conçu pour compenser l'effet du deuxième agencement quadripolaire (8) sur le faisceau d'électrons (1).

2. Dispositif à faisceau d'électrons selon la revendication 1, dans lequel le détecteur (19) est agencé de manière symétrique par rapport à l'axe de faisceau (6) du faisceau d'électrons (1) dans le dispositif à faisceau d'électrons (10).

3. Dispositif à faisceau d'électrons selon la revendication 1 ou 2, dans lequel les premier et deuxième agencements quadripolaires (7, 8) sont excités dans la même direction.

4. Dispositif à faisceau d'électrons selon l'une quelconque des revendications précédentes, dans lequel un diaphragme d'ouverture (22) est agencé devant l'un des agencements quadripolaires (8).

5. Dispositif à faisceau d'électrons selon la revendication 4, dans lequel le diaphragme d'ouverture (22) est situé entre le premier agencement quadripolaire (7) et le détecteur (19).

6. Dispositif à faisceau d'électrons selon l'une quelconque des revendications précédentes, dans lequel un troisième agencement quadripolaire (20) est prévu en plus des premier et deuxième agencements (7, 8), et les premier, deuxième et troisième agencements quadripolaires (7, 8, 20) sont connectés en série.

7. Dispositif à faisceau d'électrons selon la revendication 6, dans lequel deux agencements quadripolaires (7, 8) sont excités dans la même direction, et un autre agencement quadripolaire (20) est excité dans la direction opposée.

8. Dispositif à faisceau d'électrons selon l'une quelconque des revendications précédentes, dans lequel le détecteur (19) est agencé entre deux agencements quadripolaires (7, 8).

9. Dispositif à faisceau d'électrons selon l'une quelconque des revendications précédentes, dans lequel les agencements quadripolaires (7, 8, 20, 26, 27) sont conçus sous la forme de quadripôles magnétiques ou électrostatiques.

10. Dispositif à faisceau d'électrons selon l'une quelconque des revendications précédentes, dans lequel le deuxième agencement quadripolaire (8) est agencé plus proche de l'objet (9) que le premier agencement quadripolaire (7), et dans lequel le deuxième agencement quadripolaire (8) est agencé dans la zone de la lentille d'objectif.

11. Dispositif à faisceau d'électrons selon l'une quelconque des revendications précédentes, dans lequel le premier agencement quadripolaire (7) est agencé dans la zone du générateur de faisceau (11).

12. Dispositif à faisceau d'électrons selon l'une quelconque des revendications précédentes, dans lequel la lentille d'objectif (4, 17) a un côté dirigé vers le générateur de faisceau (11) et un côté dirigé vers l'objet (9), et est munie d'une lentille magnétique et d'une lentille électrostatique (23, 24, 25, 26), comportant des première et seconde électrodes (25, 26), la seconde électrode (26) étant agencée sur le côté dirigé vers l'objet, et à une plus petite distance de l'objet (9) que la première électrode (25), et dans lequel un des agencements quadripolaires (26, 27) est agencé sur le côté de l'objet, et la deuxième électrode (26) forme au moins partiellement cet agencement quadripolaire.

13. Dispositif à faisceau d'électrons selon la revendication 12, dans lequel un autre des agencements quadripolaires (7, 8, 20) est agencé au-dessus du croisement des électrons émis (électrons secondaires), dans lequel les électrons émis par l'objet (électrons secondaires) sont imagés.

14. Dispositif à faisceau d'électrons selon la revendication 12, dans lequel l'agencement quadripolaire comporte un composant (27) présentant une ouverture (29), et le faisceau d'électrons passe à travers cette ouverture (29) en direction de l'objet (9).

15. Dispositif à faisceau d'électrons selon la revendication 14, dans lequel l'ouverture (29) du composant (27) n'est pas de forme ronde, et est en particulier de forme elliptique.

16. Dispositif à faisceau d'électrons selon l'une quelconque des revendications 12, 14 ou 15, dans lequel le composant (27) est agencé sur la deuxième électrode (26).

17. Dispositif à faisceau d'électrons selon l'une quelconque des revendications 12 ou 14 à 16, dans lequel le composant (27) est intégré dans la deuxième électrode (26).

18. Dispositif à faisceau d'électrons selon l'une quelconque des revendications 12 ou 14 à 17, dans lequel la seconde électrode (26) présente un côté agencé du côté de l'objet, sur lequel est agencé le composant (27).

19. Dispositif à faisceau d'électrons selon la revendication 18, dans lequel le composant (27) est séparé de la deuxième électrode (26) par des isolants (28).

20. Dispositif à faisceau d'électrons selon la revendication 18 ou 19, dans lequel le composant (27) et la deuxième électrode (26) ont un potentiel pouvant être présélectionné, et dans lequel le potentiel de la deuxième électrode (26) peut être ajusté de manière variable.

21. Dispositif à faisceau d'électrons selon la revendication 20, dans lequel le composant (27) est mis à la terre.

22. Dispositif à faisceau d'électrons selon l'une quelconque des revendications précédentes, dans lequel le détecteur (19) comporte une ouverture réglable (3).

23. Dispositif à faisceau d'électrons selon l'une quelconque des revendications précédentes, dans lequel l'ouverture (3) du détecteur (19) est réalisée de forme elliptique, ou en forme de fente.

24. Dispositif à faisceau d'électrons selon la revendication 23, dans lequel le détecteur (19) est agencé dans un foyer d'un des agencements quadripolaires.

25. Dispositif à faisceau d'électrons selon l'une quelconque des revendications précédentes, dans lequel le détecteur (19) comporte au moins deux éléments détecteurs pour former l'ouverture (3).

26. Dispositif à faisceau d'électrons selon l'une quelconque des revendications précédentes, dans lequel le détecteur (19) est fabriqué sous la forme d'un diaphragme de conversion.

27. Dispositif à faisceau d'électrons (10), en particulier un microscope à balayage électronique, comportant
- un générateur de faisceau (11) pour générer un faisceau d'électrons (1),
- une lentille d'objectif (4, 17) pour focaliser le faisceau d'électrons (1) sur un objet (9), la lentille d'objectif (4, 17) ayant un côté dirigé vers le générateur de faisceau (11) et un côté dirigé vers l'objet (9),
- au moins un détecteur (19) pour une détection d'électrons (2) réfléchis par un objet (9), ou émis par celui-ci, le détecteur (19) comportant une ouverture traversante (3) pour le passage du faisceau d'électrons (1) en direction de l'objet (9),
**caractérisé par**
- au moins un agencement quadripolaire (26, 27) agencé sur le côté dirigé vers l'objet de la lentille d'objectif (4, 17).

28. Procédé pour détecter des électrons dans un dispositif à faisceau d'électrons (10), comportant les étapes consistant à générer un faisceau d'électrons principal (1), et à guider celui-ci à travers un dispositif à faisceau d'électrons (10), et à générer des électrons lorsque le faisceau d'électrons principal (1) heurte un objet devant être examiné (9), qui forment un faisceau secondaire (2), **caractérisé en ce que**
- le faisceau d'électrons principal (1) passe à travers un premier quadripôle (7), qui forme ainsi la coupe transversale de faisceau du faisceau d'électrons principal (1), le faisceau d'électrons principal (1) passant ensuite à travers l'ouverture (3) d'un détecteur (19) en direction d'un objet devant être examiné (9),
- le faisceau d'électrons principal (1) passe ensuite à travers un deuxième quadripôle (8), qui forme ainsi la coupe transversale de faisceau du faisceau d'électrons principal (1), de telle sorte qu'il est à nouveau essentiellement symétrique en rotations, et **en ce que**
- le faisceau secondaire (2) passe à travers le deuxième quadripôle (8), en étant ainsi mis en forme lors de son passage à travers le deuxième quadripôle (8), de telle sorte que seule une petite partie des électrons du faisceau secondaire (2) vont passer à travers l'ouverture du détecteur (19), et l'autre partie bien plus importante va être détectée par le détecteur (19).

29. Procédé selon la revendication 28, dans lequel le faisceau d'électrons principal (1) passe à travers un troisième quadripôle (20).
